# EUROPEAN PATENT APPLICATION

(11) **EP 1 189 283 A1**
(43) Date of publication of application: **20.03.2002**
(21) Application number: 00120333.0
(22) Date of filing: 15.09.2000
(51) Int. Cl.: H01L 25/075, H01L 33/00

(54) **Stacking-type colour-mixing LED**

(71) Applicant: Unity Opto Technology Co., Ltd., San Chung City, Taipei Hsien, Taiwan (TW)
(72) Inventor: Chin, Yuan-Cheng, Hsintien City, Taipei Hsien, Taiwan (TW)
(74) Representative: Winkler, Andreas, Dr.

(57) **Abstract**

The present invention provides a stacking-typed light-mixing LED includes a main body, more than one connecting parts, a first chip, and a second chip, wherein by mixing two lights with different wavelength, which are two lights with wavelength in the visible light spectrum area, such as the yellow light and the blue light, or the green light and the red light, excited and emitted from the first chip and the second chip, and by controlling electrical current and voltage, the two lights excited from the first chip and the second chip can be mixed into other kind of light in the visible light spectrum area, such as the white light, for having better symmetric light-mixing effect to avoid the color difference.

## Description

### Field of the Invention:

The present invention relates to a LED and, more particularly, to a LED with better light-mixing effect by stacking chips.

### Description of Related Art:

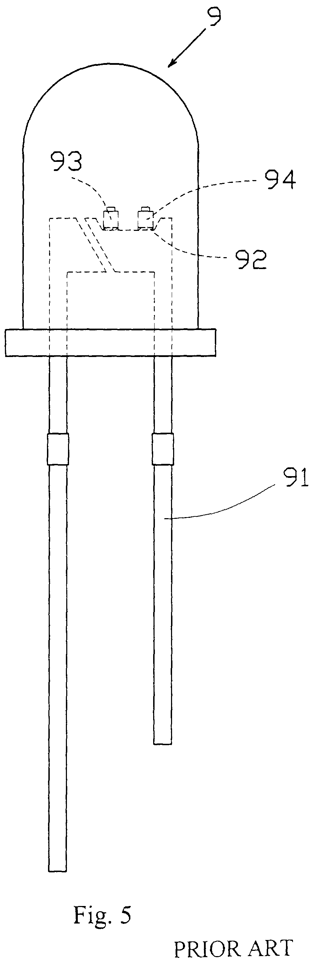

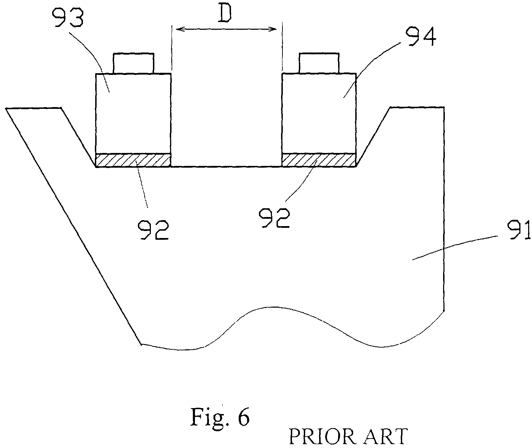

Nowadays, the present LED utilizes the blue light to excite the fluorochrome for making the fluorochrome emit the yellow light which mix with blue light to generate white light, or utilizes the parallel blue chip and yellow chip (shown in Fig. 5 and Fig. 6) to emit the white light. The blue chip 93 and the yellow chip 94 are struck on the conductive supporting frame 91 of the LED 9 by the conductive paste 92, and the electrical power via the conductive frame 91 can make the blue chip 93 emit the blue light and make the yellow chip 94 emit the yellow light, and by controlling the electrical current and voltage, the LED 9 with the character of single wavelength can make the blue light and yellow light diffuse and mix to make them present as the white light.

However, the LED 9, which have the parallel chip 93 and chip 94, would have a problem in mixing the lights and have the color fleck problem. The reason is that the distance D between the parallel chip 93 and chip 94 would induce LED shows different color on two sides of LED which blue LED chip 93 side shows blue light and yellow LED chip 94 side shows yellow light. The color of the emitted light is not symmetric. But the difficulty in processing is that the distance D between the chip 93 and the chip 94 can not be too close to have the short-circuited and leaking current problem which would introduce the problem of decreasing the yield.

### Summary of the Invention:

The main objective of the present invention is to solve the aforesaid problem and to provide a stacking-typed light-mixing LED in which by mixing two lights with different wavelength. which are two lights with wavelength in the visible light spectrum area, excited and emitted from the first chip and the second chip. and by controlling electrical current and voltage, the two lights excited from the first chip and the second chip can be mixed into other kind of light in the visible light spectrum area, such as the white light, for having better symmetric light-mixing effect to avoid the color difference.

Another objective of the present invention is to provide a stacking-typed light-mixing LED without the problem of short-circuited and leaking current by stacking the first chip and the second chip.

Other advantages and features of the present invention will be better understood with reference to the following drawings and the detailed description thereof.

### Brief Description to the Drawings:

- FIG. 1: is a schematic view showing the first embodiment of the present invention;
- FIG. 2: is a locally detailed schematic view of the FIG. 1;
- FIG. 3: is a schematic view showing the second embodiment of the present invention;
- FIG. 4: is a schematic view showing the third embodiment of the present invention;
- FIG. 5: is a schematic view showing the conventional LED; and
- FIG. 6: is a locally detailed schematic view of the FIG. 5.

### Detailed Description of the Invention:

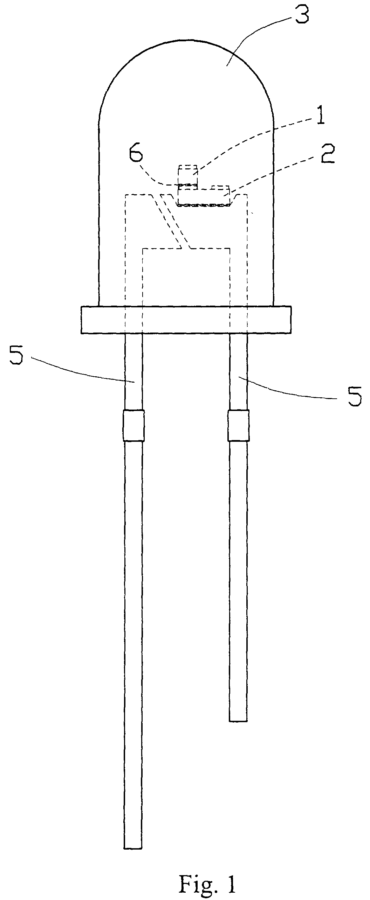

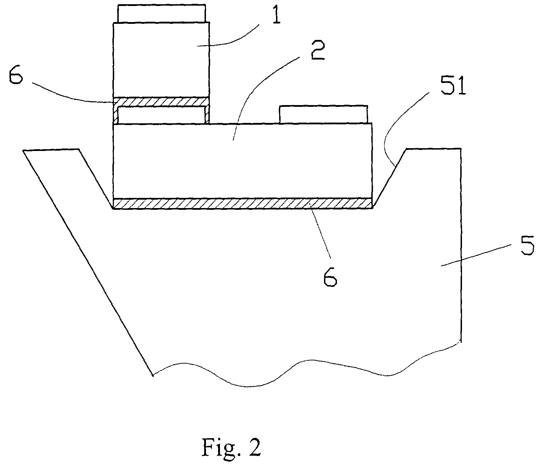

Referring to FIG. 1 and FIG. 2, the stack-typed light-mixing LED includes a translucent main body 3 which has a predetermined shape, more than one connecting parts 5 extending outwardly from the main body 3 to connect with the electrical power (not shown) and having an adopted part 51 which is a dent in the first embodiment, and the first chip 1 and the second chip 2 located on the adopted part 51 of the connecting parts 5. The first chip 1 and the second chip 2 can be separately excited to emit lights with different wavelength. The first chip 1 is stacked on the top of the second chip, and the contacting surface between the first chip and the second chip has an extrinsic semiconduction. In the first embodiment, the first chip 1 is a transparent type AIInGaN chip which can be excited to emit the yellow light. The lights emitted by the first chip 1 and the second chip 2 are in the visible light spectrum area. The top and the bottom of the first chip 1 are different materials with different extrinsic semiconduction. In the top of the first chip 1, the semiconduction is the N-typed, and in the bottom of the first chip 1, the semiconduction is the P-typed. The second chip 2 can be the InGaN on Sapphire Substrate, or the InGaN on SiC Substrate, and the second chip 2 can be excited to emit the blue light. The second chip 2 is greater than the first chip 1, and the second chip 2 has different extrinsic semiconduction, the N-typed and the P-typed, in the left side and the right side. The first chip 1 is stacked and struck on the left side of the second chip 2 with the conductive material such as the conductive paste 6.

The present invention can make the first chip 1 and the second chip 2 be excited to emit lights with different wavelength controlled by the electrical current and voltage. And the lights can be mixed into the white light. The reason is that there is no distance for the color difference, according to the first chip 1 stacked on the second chip 2, to avoid the problem of different light emitted from different side of the LED for having better symmetric effect of mixing light.

However, it should be noticed that the present invention is to let the first chip I and the second chip 2 be stacked and not be parallel for having better symmetric mixing light and reducing the distance between the first chip 1 and the second chip 2 without having the problem of short-circuited and leaking current to raise the effective production yield rate.

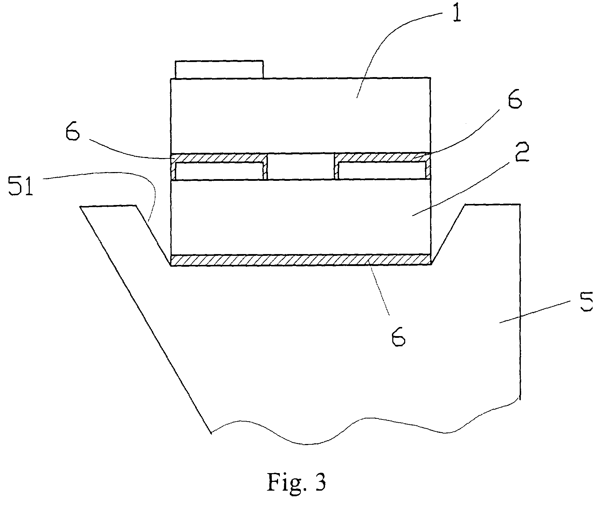

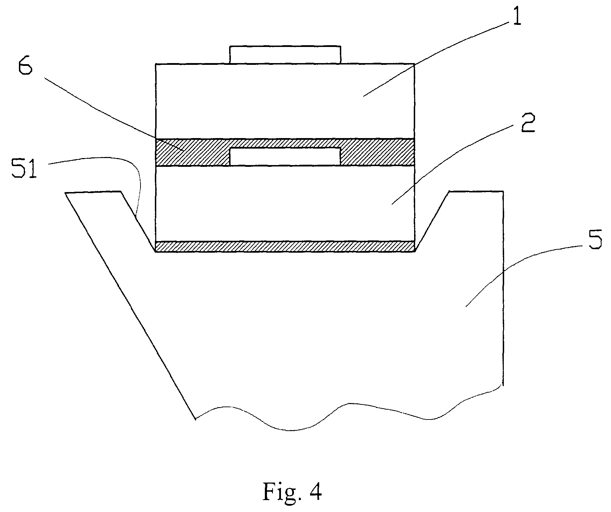

Meanwhile, the present invention is not limited by the aforesaid embodiment, and as shown in FIG. 3 and 4, the second embodiment and the third embodiment of the present invention are illustrated. In one embodiment, the chip 1 and the chip 2 are greater. In both embodiments, the size of the first chip 1 and the size of the second chip 2 are almost the same, in the top of the first chip 1 and the second chip 2 and in the bottom of the first chip 1 and the second chip 2 are different extrinsic semiconduction, and the first chip 1 and the second chip 2 are stacked and struck to each other to have the advantage of symmetric mixing light. Besides, the first chip 1 and the second chip 2 can be switched to each other. The first chip 1 can be the InGaN on Sapphire Substrate, the InGaN on SiC Substrate, or other material. The second chip 2 can be the transparent AIInGaN chip or other materials. And the lights emitted from the aforesaid first chip 1 and second chip 2 can be different light, such as the green light and the red light, and can be mixed into other light.

The present invention can make the first chip 1 and the second chip 2 be excited to emit lights with different wavelength controlled by the electrical current and voltage. The light emitted from the second chip 2 and the light emitted from the first chip 1 are in different wavelength. And the lights can be mixed into other kind of light. According to the first chip 1 stacked on the second chip 2, the symmetric effect of mixing light is better and the production rate is increased without the short-circuited and leaking current problem.

The present invention has been described hitherto with exemplary preferred embodiments. However, it is to be understood that the scope of the present invention need not be limited to the disclosed preferred embodiments. On the contrary, it is intended to cover various modifications and similar arrangements with the scope defined in the following appended claims. The scope of the claims should be accorded the broadest interpretation so as to encompass all such modifications and similar arrangements.

The features disclosed in the foregoing description, in the claims and/or in the accompanying drawings may, both separately and in any combination thereof, be material for realising the invention in diverse forms thereof.

## Claims

1. A stacking-typed light-mixing LED comprising:
a main body which is transparent with fixed shape;
more than one connecting parts extending outwardly form the main body to connect with the electrical power and having an adopted part;
a first chip and a second chip contained inside the adopted part of the main body to be excited to emit lights with different wavelength; and
wherein the first chip is stacked on the second chip and the contacting surface between the first chip and the second chip is in the extrinsic semiconduction.

2. The stacking-typed light-mixing LED of claim 1 wherein the connecting parts are two supporting parts and one of the two supporting parts has an dent as the supporting part.

3. The stacking-typed light-mixing LED of claim 1 wherein the first chip is the transparent InGaN type chip.

4. The stacking-typed light-mixing LED of claim 1 wherein the top and the bottom of the first chip are in the different extrinsic semiconduction.

5. The stacking-typed light-mixing LED of claim 1 wherein the second chip is the InGaN on sapphire substrate.

6. The stacking-typed light-mixing LED of claim 1 wherein the second chip is the InGaN on SiC substrate.

7. The stacking-typed light-mixing LED of claim 1 wherein the top and the bottom of the second chip are in the different extrinsic semiconduction.

8. The stacking-typed light-mixing LED of claim 1 wherein the first chip is the InGaN on sapphire substrate.

9. The stacking-typed light-mixing LED of claim 1 wherein the first chip is the InGaN on SiC substrate.

10. The stacking-typed light-mixing LED of claim 1 wherein the first chip and the second chip are struck by the conductive paste.

11. The stacking-typed light-mixing LED of claim 1 wherein the second chip is greater than the first chip and the first chip is stacked on a side of the second chip.

12. The stacking-typed light-mixing LED of claim 1 wherein the size of the first chip and the size of the second chip are almost the same.

13. The stacking-typed light-mixing LED of claim 1 wherein the second chip is the transparent InGaN type chip.

14. A stacking-typed light-mixing LED comprising:
a first chip and a second chip connected with the electrical power to be excited to emit lights with different wavelength; and
wherein the first chip is stacked on the second chip and the contacting surface between the first chip and the second chip is in the extrinsic semiconduction.

15. The stacking-typed light-mixing LED of claim 14 wherein the first chip is the transparent InGaN type chip.

16. The stacking-typed light-mixing LED of claim 14 wherein the top and the bottom of the first chip are in the different extrinsic semiconduction.

17. The stacking-typed light-mixing LED of claim 14 wherein the second chip is the InGaN on sapphire substrate.

18. The stacking-typed light-mixing LED of claim 14 wherein the second chip is the InGaN on SiC substrate.
